# EUROPÄISCHE PATENTSCHRIFT

(11) **EP 1 291 983 B1**
(45) Veröffentlichungstag und Bekanntmachung des Hinweises auf die Patenterteilung: **21.05.2008**
(21) Anmeldenummer: 02019743.0
(22) Anmeldetag: 03.09.2002
(51) Int. Cl.: H01R 25/16, H01R 12/16

(54) **Anschlusseinheit für elektrische Module**
Connecting unit for an electrical modul
Unité de connexion d'un module électrique

(30) Priorität: 10.09.2001 DE 10144321
(43) Veröffentlichungstag der Anmeldung: 12.03.2003
(73) Patentinhaber: Delphi Technologies, Inc., Troy, MI 48007 (US)
(72) Erfinder: Gärtner, Markus, 42855 Remscheid (DE); Giesen, Marko, 51588 Nümbrecht (DE); Trommer, Frank O., 51588 Nümbrecht (DE); Stadler, Peter, 57482 Wenden (DE); Schulte, Thomas, 58540 Meinerzhagen Windebruch (DE)
(74) Vertreter: Manitz, Finsterwald & Partner GbR

(56) Entgegenhaltungen:
- EP-A- 0 438 120
- EP-A- 0 971 461
- DE-A- 3 709 227
- DE-A- 3 928 751
- US-B1- 6 191 948

## Beschreibung

Die vorliegende Erfindung betrifft eine Anschlußeinheit für elektrische Module, insbesondere Leistungsmodule, mit einem Schaltungsträger mit mindestens einer darauf angeordneten Steckleiste für ein elektrisches Modul, über welche das Modul mit elektronischen Bauteilen oder Leiterbahnen auf dem Schaltungsträger elektrisch verbindbar ist, und elektrischen Verbindungsmitteln zum Verbinden der Module mit einer Versorgungsenergiequelle.

Derartige Anschlußeinheiten werden in verschiedenen Bereichen eingesetzt, beispielsweise im Bereich der Kraftfahrzeugelektronik. Der Schaltungsträger mit den Steckleisten ist üblicherweise mit weiteren elektrischen Bauteilen, diese untereinander und mit den Steckleisten verbindenden Leiterbahnen sowie mit Leiterbahnen für die Zufuhr von Versorgungsenergie für die in die Steckleisten eingesetzten Module versehen. Für hohe Stromstärken, beispielsweise im Bereich von 60 Ampere, müssen die Versorgungsleiterbahnen mit entsprechender Dicke ausgebildet werden. Je dicker die Leiterbahnen, desto teurer wird die Herstellung.

Die EP-A-0438120 offenbart eine Anschlusseinheit für elektrische Module, mittels welcher elektrische Leiterbahnen der Module untereinander über Stromschienen der Anschlusseinheit verbunden werden können.

Der Erfindung liegt die Aufgabe zugrunde, eine Anschlußeinheit der genannten Art anzugeben, die einen verhältnismäßig einfachen Aufbau aufweist und kostengünstig in der Herstellung ist.

Diese Aufgabe wird dadurch gelöst, daß die elektrischen Verbindungsmittel durch vom Schaltungsträger getrennte Stromschienen gebildet sind und dass die Stromschienen auch Anschlüsse zur elektrischen Verbindung mit dem Schaltungsträger aufweisen.

Durch die Verwendung von separaten Stromschienen für die Energieversorgung der Module können die Herstellungskosten deutlich gesenkt werden. Es sind durch diese Ausgestaltung keine Versorgungs-Leiterbahnen auf dem Schaltungsträger mehr erforderlich, die bei großen Stromstärken mit großer Dicke hergestellt werden müssen. Stattdessen können die Stromschienen aus geeignetem Material, insbesondere Kupfer, ausgestanzt oder ausgeschnitten werden. Der gesamte Verfahrensschritt des Auflaminierens der Versorgungsleiterbahnen auf dem Schaltungsträger entfällt damit. Die Stromschienen können außerdem verhältnismäßig groß ausgebildet werden, so daß sie keine Wärmequelle bilden, sondern selbst wärmeableitend wirken können.

Zur Versorgung von Bauteilen auf dem Schaltungsträger sind die Stromschienen nach der Erfindung auch mit Anschlüssen zur elektrischen Verbindung mit dem Schaltungsträger versehen. Diese werden insbesondere durch in Richtung auf den Schaltungsträger abgewinkelte Abschnitte der Stromschienen gebildet, was wiederum in der Herstellung günstig ist.

Eine besonders große Ausbildung der Stromschienen kann dadurch ermöglicht werden, daß die Stromschienen auf der den Steckleisten abgewandten Seite des Schaltungsträgers angeordnet sind und durch den Schaltungsträger hindurchgreifende Abschnitte aufweisen, über welche die Stromschienen mit den Modulen elektrisch verbindbar sind. Im wesentlichen die gesamte Fläche unterhalb des Schaltungsträgers steht damit für die Stromschienen zur Verfügung. Um diese optimal auszunutzen, sind die Stromschienen bevorzugt als parallel zum Schaltungsträger angeordnete, im wesentlichen flache Profile ausgebildet.

Herstellungstechnisch vorteilhaft ist es, wenn die durch den Schaltungsträger hindurchgreifenden Abschnitte durch Abwinkeln der Stromschienen gebildet sind. Die Abschnitte sind außerdem bevorzugt als Steckelemente ausgebildet, insbesondere als sogenannte Stimmgabelkontakte. Die Module können dadurch einfach beim Einsetzen in die Steckleisten auf diese Kontakte mit aufgesteckt werden, um die elektrische Verbindung zur Stromversorgung herzustellen.

Eine weitere vorteilhafte Ausgestaltung ergibt sich durch Anordnung der beiden Stromschienen übereinander, wobei zwischen den beiden Stromschienen eine elektrische Isolierung, insbesondere eine Folie, vorgesehen ist, um die beiden Stromschienen elektrisch voneinander zu trennen. Die Isolierfolie wird dabei bevorzugt ohne Verkleben zwischen die Stromschienen zwischengelegt. Hierdurch kann der Herstellungsaufwand weiter verringert werden.

Nach einer weiteren Ausgestaltung der Erfindung sind die Stromschienen in das Unterteil eines zweiteiligen Gehäuses eingelegt, dessen Oberteil den Schaltungsträger im wesentlichen bis auf die Steckleisten abdeckt. Hierdurch ergibt sich ein besonders geschickter, in der Herstellung günstiger Aufbau.

Zwischen den beiden Gehäuseteilen und zwischen dem oberen Gehäuseteil und den Gehäusen der Module ist bevorzugt jeweils eine Dichtung vorgesehen. Das Gehäuse kann dadurch feuchtigkeitsdicht ausgebildet werden, so daß die Anschlußeinheit auch bei Feuchtegefahr eingesetzt werden kann, beispielsweise im Motorraum von Kraftfahrzeugen.

Die Stromschienen und der Schaltungsträger sind bevorzugt in das Gehäuseunterteil eingelegt und durch Vorsprünge positioniert. Besondere Befestigungsmaßnahmen wie Verschrauben oder Verkleben können dadurch eingespart werden, so daß der Zusammenbau der Anschlußeinheit vereinfacht ist.

Nach einer weiteren Ausgestaltung der Erfindung sind zwei Paare von Stromschienen zur Versorgung der Module mit unterschiedlichen Spannungen vorgesehen, wobei beide Paare bevorzugt Anschlüsse für jedes Modul aufweisen. Die Module können dadurch bei Bedarf wahlweise mit zwei verschiedenen Spannungen, beispielsweise 12 Volt und 42 Volt versorgt werden, wobei die Versorgung in beiden Fällen über die erfindungsgemäßen Stromschienen erfolgt, so daß die oben erwähnten Vorteile gegeben sind.

Die beiden Paare von Stromschienen sind bevorzugt mit geringem Abstand nebeneinander angeordnet. Sie können dadurch größtmögliche Abmessungen aufweisen, so daß eine geringe Wärmeerzeugung und eine große Wärmeabfuhr gegeben sind.

Zwischen den beiden Paaren von Stromschienen greift nach einer weiteren Ausgestaltung der Erfindung eine Rippe des Gehäuseunterteils hindurch, auf welcher der Schaltungsträger abgestützt ist. Die beim Einstecken von Modulen auftretenden Kräfte können dadurch besser abgefangen werden.

Ebenso ist es vorteilhaft und daher bevorzugt, wenn die Abschnitte zum elektrischen Anschließen des Schaltungsträgers als Steckkontakte ausgebildet sind. Beim Zusammenbau der Anschlußeinheit genügt es dadurch, den Schaltungsträger auf die in das Gehäuse eingelegten Stromschienen aufzudrücken.

Nach noch einer Ausgestaltung der Erfindung sind insbesondere an dem Gehäuse verankerte Halteklammern vorgesehen, durch welche eingesteckte Module auf dem Schaltungsträger fixierbar sind. Damit kann einem Lösen oder Abknicken der Module entgegengewirkt werden. Dies ist insbesondere bei verhältnismäßig großen und massiven Modulen wie beispielsweise Modulen mit Kühlkörper von Bedeutung.

Bevorzugt ist es, wenn die Halteklammern automatisch am Gehäuse der Module einrastbar ausgebildet sind. Das Anbringen und Fixieren von Modulen kann dadurch vereinfacht werden.

Ausführungsbeispiele der Erfindung sind in der Zeichnung dargestellt und werden nachfolgend beschrieben. Es zeigen, jeweils in schematischer Darstellung,
- Fig. 1: eine perspektivische Ansicht einer erfindungsgemäßen Anschlußeinheit mit eingesteckten Leistungsmodulen,
- Fig. 2: die Anschlußeinheit von Fig. 1 ohne Module,
- Fig. 3: die Anschlußeinheit von Fig. 2 mit entferntem Deckel und
- Fig. 4: einen Teil der Anschlußeinheit ebenfalls in perspektivischer Darstellung.

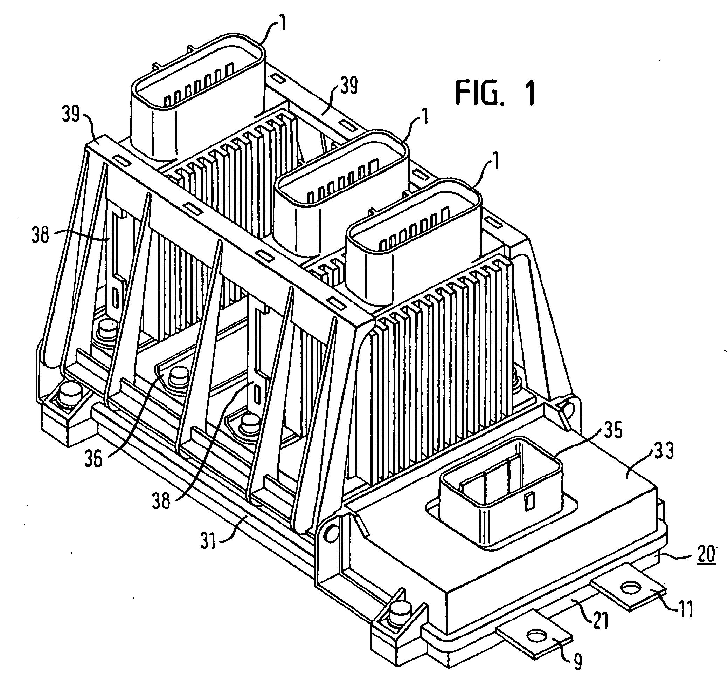

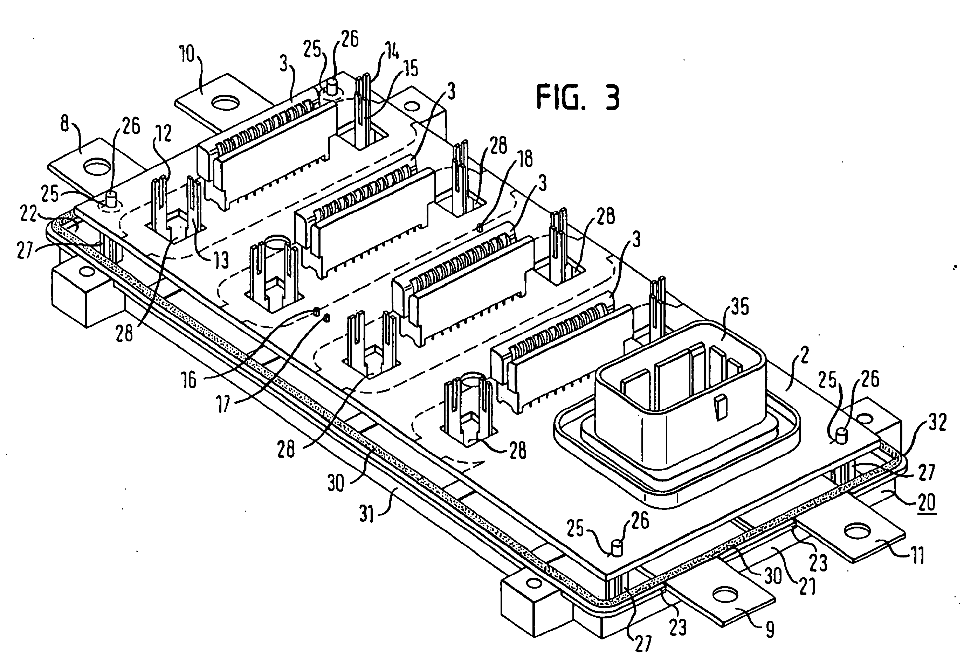

Die in den Zeichnungen dargestellte Anschlußeinheit kann, wie in Fig. 1 dargestellt, mit Leistungsmodulen 1 bestückt werden, die jeweils in eine auf einem in Fig. 3 erkennbaren Schaltungsträger 2 angeordnete Steckleiste 3 einsteckbar sind. Über die Steckleisten 3 sind die Module 1 jeweils mit elektronischen Bauteilen oder Leiterbahnen auf dem Schaltungsträger 2 elektrisch verbindbar. Darüber hinaus sind die Module 1 in der nachfolgend beschriebenen Weise mit der Energieversorgung dienenden Stromschienen 4, 5, 6, 7 elektrisch verbindbar.

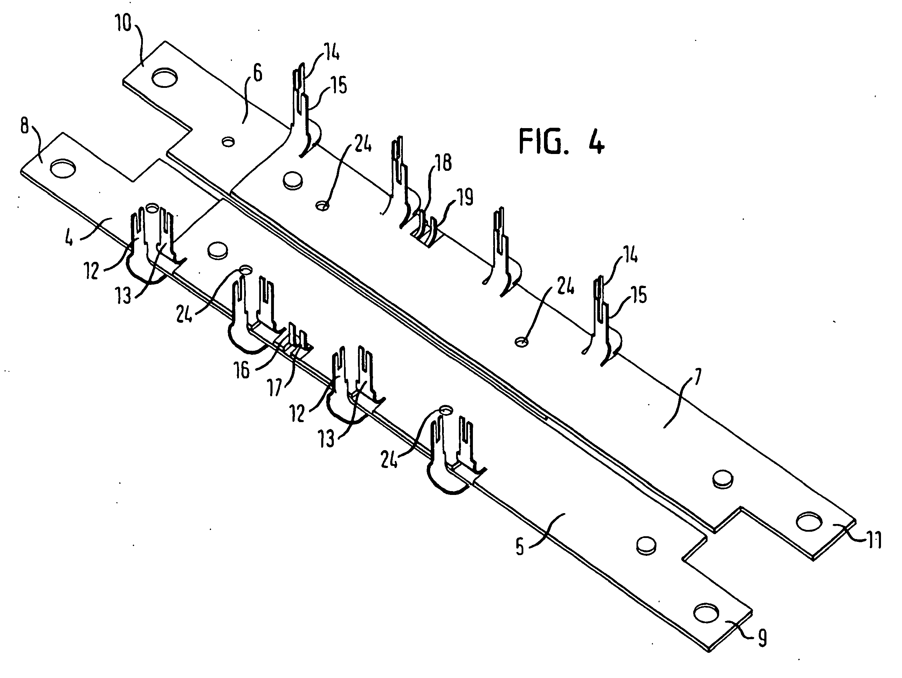

Wie insbesondere in Fig. 4 erkennbar, sind jeweils zwei als flache, längliche Profile ausgebildete Stromschienen 4, 5 und 6, 7 übereinander und mit geringem Abstand paarweise nebeneinander angeordnet.

Zwischen den beiden Stromschienen 4, 5, 6, 7 eines jeden Stromschienenpaares ist eine Folie aus isolierendem Material angeordnet, wobei die Folie bevorzugt ohne Verkleben zwischen die beiden Stromschienen 4, 5 und 6, 7 zwischengelegt ist.

Die Stromschienen 4, 5, 6, 7 weisen jeweils an einem Ende Anschlußzungen 8, 9, 10, 11 auf, wobei die Anschlußzungen 8, 10 der unteren Stromschienen 4, 6 am einen Ende und die Anschlußzungen 9, 11 der oberen Stromschiene 5, 7 am anderen Ende vorgesehen sind. Über die Anschlußzungen 8, 9, 10, 11 sind die Stromschienen 4, 5, 6, 7 mit elektrischen Anschlußleitungen verbindbar.

Die Stromschienen 4, 5, 6, 7 sind außerdem mit nach oben vorstehenden Abwinklungen 12, 13, 14, 15 versehen, die in Form von Stimmgabelkontakten ausgebildet sind. Jede Stromschiene 4, 5, 6, 7 weist in ihrem seitlichen Außenbereich vier in ihrer Längsrichtung voneinander beabstandete derartige Stimmgabelkontakte 12, 13, 14, 15 auf, wobei die Stimmgabelkontakte 12, 14 der unteren Stromschienen 4, 6 jeweils benachbart zu einem Stimmgabelkontakt 13, 15 der zugeordneten oberen Stromschiene 5, 7 angeordnet sind. Somit werden jeweils benachbarte Kontaktpaare 12, 13 und 14, 15 gebildet, von denen jeweils eines des ersten Stromschienenpaares 4, 5 und eines des zweiten Stromschienenpaares 6, 7 einem Modul 1 zugeordnet ist. Ein Kontaktschienenpaar 4, 5 kann so jedem Modul 1 eine erste gewünschte Spannung, beispielsweise 12 Volt, und das andere Stromschienenpaar 6, 7 eine zweite gewünschte Spannung, beispielsweise 42 Volt, zur Verfügung stellen. Zusätzlich sind die Stromschienen 4, 5, 6, 7 mit einer kleinen stiftartigen Abwinklung 16, 17, 18, 19 versehen, die in dieselbe Richtung weist wie die Stimmgabelkontakte 12, 13, 14, 15.

Wie man insbesondere in Figur 3 erkennt, sind die Stromschienen 4, 5, 6, 7 in ein Gehäuseunterteil 20 eingesetzt, welches im wesentlichen rechtwinklige Abmessungen aufweist. Zur Fixierung der Stromschienen 4, 5, 6, 7 weist das Gehäuseunterteil in seinen Seitenwänden 21 und 22 Ausnehmungen 23 auf. Außerdem sind hier nicht erkennbare Stifte vorgesehen, die in Ausnehmungen 24 (Figur 4) der Stromschienen 4, 5, 6, 7 eingreifen.

Oberhalb der Stromschienen 4, 5, 6, 7 trägt das Gehäuseunterteil 20 den Schaltungsträger 2. Dieser ist hierfür mit Durchtrittsöffnungen 25 versehen, die jeweils von dem verjüngten Abschnitt 26 eines im Gehäuseunterteil 20 vorgesehenen gestuften Stiftes 27 durchgriffen werden. Darüber hinaus stützt sich der Schaltungsträger 2 auf einer hier nicht erkennbaren Rippe ab, die zwischen den beiden Stromschienenpaaren 4, 5, 6, 7 hindurchgreift.

Der Schaltungsträger 2 ist desweiteren mit Durchbrüchen 28 versehen, durch welche die Stimmgabelkontakte 12, 13, 14, 15 der Stromschienen 4, 5, 6, 7 hindurchgreifen. Wie man in Figur 3 erkennt, sind die Stimmgabelkontakte 12, 13, 14, 15 so positioniert, daß jeweils ein Kontaktpaar 12, 13 des einen Stromschienenpaares 4, 5 und ein Kontaktpaar 14, 15 des anderen Stromschienenpaares 6, 7 auf einer der beiden Schmalseiten der Steckleisten 3 angeordnet ist. Wie man ebenfalls in Figur 3 erkennt, greifen die Kontaktfinger 16, 17, 18, 19 außerdem von unten her in entsprechende Ausnehmungen des Schaltungsträgers 2 ein. Sie stellen dabei einen Kontakt mit einer zugeordneten Anschlußstelle des Schaltungsträgers 2 her. Außerdem erkennt man in Figur 3 noch eine umlaufende Dichtung 30 auf der Oberseite der Seitenwände 21 und 22 sowie der Oberseite der weiteren Seitenwände 31 und 32 des Gehäuseunterteils 20.

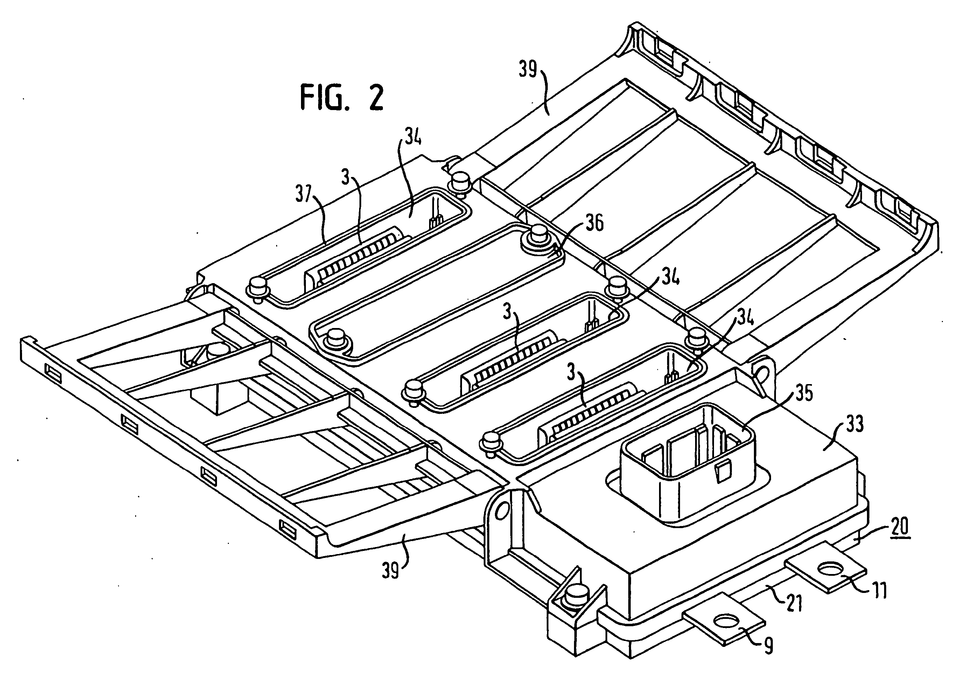

In den Figuren 1 und 2 erkennt man, daß der Schaltungsträger 2 im wesentlichen mit einem Gehäuseoberteil 33 abgedeckt ist, welches auf das Gehäuseteil 20 dichtend aufsetzbar ist. Das Gehäuseoberteil 33 weist Aussparungen 34 im Bereich der Steckleisten 3 und der Stimmgabelkontakte 12, 13, 14, 15 sowie im Bereich der auf dem Schaltungsträger 2 vorhandenen Datenbusverbindung 35 auf. Die Ausnehmungen 34 im Bereich nicht benutzter Steckleisten 3 können mit einer Abdeckplatte 36 abgedeckt werden, die auf das Gehäuseoberteil 33 beispielsweise aufschraubbar ist. Um die Ausnehmungen 34 sind Dichtungen 37 angeordnet, die entweder mit der Abdeckplatte 36 oder dem Gehäuse 38 der Module 1 zusammenwirken, so daß das Innere des Gehäuses 20, 33 vollständig abgedichtet werden kann.

Außerdem sind am Gehäuseoberteil 33 seitlich zwei Halteklammern 39 schwenkbar angebracht, die in ihrer in Figur 1 dargestellten hochgeschwenkten Stellung die Gehäuse 38 der Module 1 klemmend übergreifen. Zusätzlich können die Gehäuse 38 der Module 1, wie in Figur 1 dargestellt, jedoch mit dem Gehäuseoberteil 33 auch verschraubt sein.

Zur Herstellung der erfindungsgemäßen Anschlußeinheit werden die Stromschienen 4, 5, 6, 7 nach Ausstanzen oder Ausschneiden und Hochbiegen der Abschnitte 12, 13, 14, 15 und 16, 17, 18, 19 in das Gehäuseunterteil 20 eingelegt, in welchem sie durch die Ausnehmungen 23 und die nicht dargestellten Stifte fixiert sind. Danach wird der mit den Steckleisten 3 und dem Datenbus 35 sowie den weiteren elektronischen Bauteilen und Leiterbahnen versehene Schaltungsträger 2 auf die gestuften Vorsprünge 27 des Gehäuseunterteils 20 aufgesetzt, wobei die Stimmgabelkontakte 12, 13, 14, 15 der Kontaktschienen 4, 5, 6, 7 durch die Aussparungen 28 des Schaltungsträgers 2 hindurchgreifen.

Nach Aufbringen der umlaufenden Dichtung 30 wird das Gehäuseoberteil 33 mit den Klemmbügeln 39 auf das Gehäuseunterteil 20 aufgesetzt und beispielsweise durch Verschrauben an diesem befestigt. Nun können Leistungsmodule 1 in die Steckleisten 3 eingesetzt und beispielsweise durch Verschrauben an dem Gehäuseoberteil 33 befestigt werden. Zusätzlich werden die Leistungsmodule 1 durch Hochschwenken der Halteklammern 39 am Gehäuseoberteil 33 fixiert. Im Bereich von nicht mit Leistungsmodulen 1 bestückten Steckleisten 3 können die Ausnehmungen 34 des Gehäuseoberteils 33 mit Abdeckplatten 36 abgedeckt werden, die ebenfalls beispielsweise durch Verschrauben am Gehäuseoberteil 33 befestigt werden können. Über die um die Ausnehmungen 34 vorgesehenen Dichtungen 37 ist das Innere des Gehäuses 20, 33 abgedichtet.

Durch die Erfindung wird eine Anschlußeinheit zur Verfügung gestellt, die einen vereinfachten Aufbau aufweist und daher kostengünstig herstellbar ist. Durch die Verwendung von Stromschienen 4, 5, 6, 7, die als von dem Schaltungsträger 2 separate Bauteile ausgebildet sind, entfällt das insbesondere bei großen Stromstärken kostenintensive Aufbringen von Energieversorgungsleiterbahnen auf dem Schaltungsträger 2. Die separaten Stromschienen 4, 5, 6, 7 ermöglichen außerdem einen großen Leitungsquerschnitt und damit eine verringerte Wärmebildung. Durch die großflächige Ausbildung der Stromschienen 4, 5, 6, 7 wird außerdem eine zusätzliche gute Wärmeabfuhr erreicht.

### Bezugszeichenliste

- 1: Leistungsmodul
- 2: Schaltungsträger
- 3: Steckleiste
- 4: Stromschiene
- 5: Stromschiene
- 6: Stromschiene
- 7: Stromschiene
- 8: Anschlußzunge
- 9: Anschlußzunge
- 10: Anschlußzunge
- 11: Anschlußzunge
- 12: Stimmgabelkontakt
- 13: Stimmgabelkontakt
- 14: Stimmgabelkontakt
- 15: Stimmgabelkontakt
- 16: Kontaktfinger
- 17: Kontaktfinger
- 18: Kontaktfinger
- 19: Kontaktfinger
- 20: Gehäuseunterteil
- 21: Seite von 20
- 22: Seite von 20
- 23: Ausnehmung
- 24: Ausnehmung
- 25: Ausnehmung
- 26: Abschnitt von 27
- 27: gestufter Stift
- 28: Durchbrechung
- 29:
- 30: Dichtung
- 31: Seite von 20
- 32: Seite von 20
- 33: Gehäuseoberteil
- 34: Ausnehmung
- 35: Datenbus
- 36: Abdeckplatte
- 37: Dichtung
- 38: Gehäuse von 1
- 39: Halteklammer

## Patentansprüche

1. Anschlußeinheit für elektrische Module (1), insbesondere Leistungsmodule, mit einem Schaltungsträger (2) mit mindestens einer darauf angeordneten Steckleiste (3) für ein elektrisches Modul (1), über welche das Modul (1) mit elektronischen Bauteilen oder Leiterbahnen auf dem Schaltungsträger (2) elektrisch verbindbar ist, und elektrischen Verbindungsmitteln (4, 5, 6, 7) zum Verbinden der Module (1) mit einer Versorgungsenergiequelle,
**dadurch gekennzeichnet,**
**daß** die elektrischen Verbindungsmittel durch vom Schaltungsträger (2) getrennte Stromschienen (4, 5, 6, 7) gebildet sind und daß die Stromschienen (4, 5, 6, 7) auch Anschlüsse (16, 17, 18, 19) zur elektrischen Verbindung mit dem Schaltungsträger (2) aufweisen.

2. Anschlußeinheit nach Anspruch 1,
**dadurch gekennzeichnet,**
**daß** die Stromschienen (4, 5, 6, 7) auf der den Steckleisten (3) abgewandten Seite des Schaltungsträgers (2) angeordnet sind und durch den Schaltungsträger (2) hindurchgreifende Abschnitte (12, 13, 14, 15) aufweisen, über welche die Stromschienen (4, 5, 6, 7) mit den Modulen (1) elektrisch verbindbar sind.

3. Anschlußeinheit nach Anspruch 1 oder 2,
**dadurch gekennzeichnet,**
**daß** die Stromschienen (4, 5, 6, 7) als parallel zum Schaltungsträger (2) angeordnete, im wesentlichen flache Profile ausgebildet sind.

4. Anschlußeinheit nach Anspruch 3,
**dadurch gekennzeichnet,**
**daß** die durch den Schaltungsträger (2) hindurchgreifenden Abschnitte (12, 13, 14, 15) durch Abwinkeln der Stromschienen (4, 5, 6, 7) gebildet sind.

5. Anschlußeinheit nach einem der Ansprüche 2 bis 4,
**dadurch gekennzeichnet,**
**daß** die Abschnitte (12, 13, 14, 15) als Steckelemente, insbesondere sogenannte Stimmgabelkontakte ausgebildet sind.

6. Anschlußeinheit nach einem der Ansprüche 3 bis 5,
**dadurch gekennzeichnet,**
**daß** die beiden Stromschienen (4, 5; 6, 7) übereinander angeordnet und durch eine elektrische Isolierung, insbesondere Folie, voneinander getrennt sind.

7. Anschlußeinheit nach Anspruch 6,
**dadurch gekennzeichnet,**
**daß** die Isolierfolie ohne Verkleben zwischen die Stromschienen (4, 5; 6, 7) zwischengelegt ist.

8. Anschlußeinheit nach einem der vorhergehenden Ansprüche,
**dadurch gekennzeichnet,**
**daß** die Stromschienen (4, 5, 6, 7) in das Unterteil (20) eines zweiteiligen Gehäuses eingelegt sind, dessen Oberteil (33) den Schaltungsträger (2) im wesentlichen bis auf die Steckleisten (3) abdeckt.

9. Anschlußeinheit nach Anspruch 8,
**dadurch gekennzeichnet,**
**daß** zwischen den beiden Gehäuseteilen (20, 33) und zwischen dem oberen Gehäuseteil (33) und den Gehäusen (38) der Module (1) jeweils eine Dichtung vorgesehen ist.

10. Anschlußeinheit nach Anspruch 8 oder 9,
**dadurch gekennzeichnet,**
**daß** die Stromschienen (4, 5, 6, 7) und der Schaltungsträger (2) in das Gehäuseunterteil (20) eingelegt und durch Vorsprünge positioniert sind.

11. Anschlußeinheit nach einem der vorhergehenden Ansprüche,
**dadurch gekennzeichnet,**
**daß** zwei Paare von Stromschienen (4, 5; 6, 7) zur Versorgung der Module (1) mit unterschiedlichen Spannungen vorgesehen sind.

12. Anschlußeinheit nach Anspruch 11,
**dadurch gekennzeichnet,**
**daß** beide Paare von Stromschienen (4, 5; 6, 7) Anschlüsse für jedes Modul (1) aufweisen.

13. Anschlußeinheit nach Anspruch 11 oder 12,
**dadurch gekennzeichnet,**
**daß** die beiden Paare von Stromschienen (4, 5; 6, 7) mit geringem Abstand nebeneinander angeordnet sind.

14. Anschlußeinheit nach Anspruch 13,
**dadurch gekennzeichnet,**
**daß** zwischen den beiden Paaren von Stromschienen (4, 5; 6, 7) eine Rippe des Gehäuseunterteils (20) hindurchgreift, auf welcher der Schaltungsträger (2) abgestützt ist.

15. Anschlußeinheit nach einem der vorhergehenden Ansprüche,
**dadurch gekennzeichnet,**
**daß** die Anschlüsse (16, 17, 18, 19) durch in Richtung auf den Schaltungsträger (2) abgewinkelte Abschnitte der Stromschienen (4, 5, 6, 7) gebildet sind.

16. Anschlußeinheit nach Anspruch 15,
**dadurch gekennzeichnet,**
**daß** die Abschnitte (16, 17, 18, 19) als Steckkontakte ausgebildet sind.

17. Anschlußeinheit nach einem der vorhergehenden Ansprüche,
**dadurch gekennzeichnet,**
**daß** insbesondere an dem Gehäuseoberteil (33) verankerte Halteklammern (39) vorgesehen sind, durch welche eingesteckte Module (1) auf dem Leitungsträger (2) fixierbar sind.

18. Anschlußeinheit nach Anspruch 17,
**dadurch gekennzeichnet,**
**daß** die Halteklammern (39) automatisch am Gehäuse (38) der Module (1) einrastbar ausgebildet sind.

## Claims

1. A connector unit for electrical modules (1), in particular power modules, having a circuit carrier (2) with at least one plug rail (3) arranged thereon for an electrical module (1) via which the module (1) can be electrically connected to electronic components or conductor tracks on the circuit carrier (2), and having electrical connection means (4, 5, 6, 7) for connecting the modules (1) to a power source,
**characterized in that** the electrical connection means are formed by busbars (4, 5, 6, 7) separate from the circuit carrier (2); and **in that** the busbars (4, 5, 6, 7) also have connectors (16, 17, 18, 19) for the electrical connection to the circuit carrier (2).

2. A connector unit in accordance with claim 1, **characterized in that** the busbars (4, 5, 6, 7) are arranged on the side of the circuit carrier (2) remote from the plug rails (3) and have sections (12, 13, 14, 15) engaging through the circuit carrier (2) via which the busbars (4, 5, 6, 7) can be electrically connected to the modules (1).

3. A connector unit in accordance with claim 1 or claim 2,
**characterized in that** the busbars (4, 5, 6, 7) are made as substantially flat sections arranged parallel to the circuit carrier (2).

4. A connector unit in accordance with claim 3, **characterized in that** the sections (12, 13, 14, 15) engaging through the circuit carrier (2) are formed by bending the busbars (4, 5, 6, 7).

5. A connector unit in accordance with any one of the claims 2 to 4,
**characterized in that** the sections (12, 13, 14, 15) are made as plug elements, in particular as so-called tuning fork contacts.

6. A connector unit in accordance with any one of the claims 3 to 5,
**characterized in that** the two busbars (4, 5; 6, 7) are arranged above one other and are separated from one another by an electrical insulation, in particular a film.

7. A connector unit in accordance with claim 6, **characterized in that** the insulating film is interposed between the busbars (4, 5; 6, 7) without adhesive bonding.

8. A connector unit in accordance with any one of the preceding claims, **characterized in that** the busbars (4, 5, 6, 7) are inserted into the lower part (20) of a two-part housing whose upper part (33) substantially covers the circuit carrier (2) with the exception of the plug rails (3).

9. A connector unit in accordance with claim 8, **characterized in that** a respective seal is provided between the two housing parts (20, 33) and between the upper housing part (33) and the housings (38) of the modules (1).

10. A connector unit in accordance with claim 8 or claim 9,
**characterized in that** the busbars (4, 5, 6, 7) and the circuit carrier (2) are inserted into the lower housing part (20) and are positioned by projections.

11. A connector unit in accordance with any one of the preceding claims, **characterized in that** two pairs of busbars (4, 5; 6, 7) are provided to supply the modules (1) with different voltages.

12. A connector unit in accordance with claim 11, **characterized in that** both pairs of busbars (4, 5; 6, 7) have connectors for each module (1).

13. A connector unit in accordance with claim 11 or claim 12,
**characterized in that** both pairs of busbars (4, 5; 6, 7) are arranged next to one another at a small spacing.

14. A connector unit in accordance with claim 13, **characterized in that** a rib of the lower housing part (20), on which the circuit carrier (2) is supported, engages between the two pairs of busbars (4, 5; 6, 7).

15. A connector unit in accordance with any one of the preceding claims, **characterized in that** the connectors (16, 17, 18, 19) are formed by sections of the busbars (4, 5, 6, 7) bent in the direction of the circuit carrier (2).

16. A connector unit in accordance with claim 15, **characterized in that** the sections (16, 17, 18, 19) are made as plug contacts.

17. A connector unit in accordance with any one of the preceding claims, **characterized in that** holding clamps (39) are provided, in particular anchored to the upper housing part (33), through which inserted modules (1) can be fixed to the circuit carrier (2).

18. A connector unit in accordance with claim 17, **characterized in that** the holding clamps (39) are formed automatically latchable at the housing (38) of the modules (1).

## Revendications

1. Unité de raccordement pour modules électriques (1), en particulier des modules de puissance, comprenant un support de circuit (2) avec au moins un connecteur multipoints (3) disposé sur celui-ci pour un module électrique (1), le connecteur multipoints permettant de relier le module (1) électriquement à des composants électroniques ou des pistes conductives sur le support de circuit (2), et des moyens de connexion électrique (4, 5, 6, 7) pour relier les modules (1) à une source d'énergie d'alimentation,
**caractérisée en ce que**
les moyens de connexion électrique sont formés par des barres conductrices (4, 5, 6, 7) séparées du support de circuit (2) et **en ce que** les barres conductrices (4, 5, 6, 7) présentent aussi des connecteurs (16, 17, 18, 19) pour une connexion électrique au support de circuit (2).

2. Unité de raccordement selon la revendication 1, **caractérisée en ce que** les barres conductrices (4, 5, 6, 7) sont disposées du côté du support de circuit (2), détourné des connecteurs multipoints (3), et présentent des sections (12, 13, 14, 15) passant à travers le support de circuit (2) par l'intermédiaire desquelles les barres conductrices (4, 5, 6, 7) peuvent être reliées électriquement aux modules (1).

3. Unité de raccordement selon la revendication 1 ou 2, **caractérisée en ce que** les barres conductrices (4, 5, 6, 7) sont réalisées comme des profilés substantiellement plats, disposés en parallèle au support de circuit (2).

4. Unité de raccordement selon la revendication 3, **caractérisée en ce que** les sections (12, 13, 14, 15) passant à travers le support de circuit (2) sont réalisées par pliage des barres conductrices (4, 5, 6, 7).

5. Unité de raccordement selon l'une quelconque des revendications 2 à 4, **caractérisée en ce que** les sections (12, 13, 14, 15) sont réalisées comme des éléments à enficher, en particulier comme des contacts dits contacts lyres.

6. Unité de raccordement selon l'une quelconque des revendications 3 à 5, **caractérisée en ce que** les deux barres conductrices (4, 5 ; 6, 7) sont disposées l'une au-dessus de l'autre et séparées l'une de l'autre par une isolation électrique, en particulier une feuille.

7. Unité de raccordement selon la revendication 6, **caractérisée en ce que** la feuille isolante est interposée entre les barres conductrices (4, 5 ; 6, 7) sans collage.

8. Unité de raccordement selon l'une quelconque des revendications précédentes, **caractérisée en ce que** les barres conductrices (4, 5, 6, 7) sont insérées dans la partie inférieure (20) d'un boîtier en deux parties dont la partie supérieure (33) recouvre le support de circuit (2) substantiellement à l'exception des connecteurs multipoints (3).

9. Unité de raccordement selon la revendication 8, **caractérisée en ce qu'**entre les deux parties de boîtier (20, 33) et entre la partie de boîtier supérieure (33) et les boîtiers (38) des modules (1) respectivement un joint est prévu.

10. Unité de raccordement selon la revendication 8 ou 9, **caractérisée en ce que** les barres conductrices (4, 5, 6, 7) et le support de circuit (2) sont insérés dans la partie inférieure de boîtier (20) et positionnés à l'aide de saillies.

11. Unité de raccordement selon l'une quelconque des revendications précédentes, **caractérisée en ce que** deux paires de barres conductrices (4, 5 ; 6, 7) sont prévues pour alimenter les modules (1) avec des tensions différentes.

12. Unité de raccordement selon la revendication 11, **caractérisée en ce que** les deux paires de barres conductrices (4, 5 ; 6, 7) présentent des raccordements pour chaque module (1).

13. Unité de raccordement selon la revendication 11 ou 12, **caractérisée en ce que** les deux paires de barres conductrices (4, 5 ; 6, 7) sont disposées côte à côte à faible distance.

14. Unité de raccordement selon la revendication 13, **caractérisée en ce qu'**une nervure de la partie inférieure de boîtier (20) pénètre entre les deux paires de barres conductrices (4, 5 ; 6, 7), nervure sur laquelle repose le support de circuit (2).

15. Unité de raccordement selon l'une quelconque des revendications précédentes, **caractérisée en ce que** les connecteurs (16, 17, 18, 19) sont formés par des sections des barres conductrices (4, 5, 6, 7), pliées en direction du support de circuit (2).

16. Unité de raccordement selon la revendication 15, **caractérisée en ce que** les sections (16, 17, 18, 19) sont réalisées comme des contacts à fiche.

17. Unité de raccordement selon l'une quelconque des revendications précédentes, **caractérisée en ce qu'**en particulier sur la partie supérieure de boîtier (33), des attaches de fixation ancrées (39) sont prévues qui permettent de fixer des modules enfichés (1) sur le support de ligne (2).

18. Unité de raccordement selon la revendication 17, **caractérisée en ce que** les attaches de fixation (39) sont réalisées de façon à s'enclencher automatiquement sur le boîtier (38) des modules (1).
